# EUROPEAN PATENT APPLICATION

(11) **EP 4 071 522 A1**
(43) Date of publication of application: **12.10.2022**
(21) Application number: 20897482.4
(22) Date of filing: 29.10.2020
(51) Int. Cl.: G02B 1/111, C01B 33/12, C23C 26/00, C23C 28/04, C25D 11/18, C25D 11/22, C25D 11/26, G02B 1/10, G03F 1/64

(54) **OPTICAL MEMBER AND PRODUCTION METHOD THEREFOR**

(30) Priority: 02.12.2019 JP 2019217700
(71) Applicant: Nippon Light Metal Co., Ltd., Minato-ku Tokyo 105-0004 (JP)
(72) Inventor: IIZUKA Akira, Shizuoka-shi, Shizuoka 421-3203 (JP); OSHIMA Takeshi, Shizuoka-shi, Shizuoka 421-3203 (JP); NAKANO Koichi, Shizuoka-shi, Shizuoka 421-3203 (JP)
(74) Representative: Mewburn Ellis LLP
(86) International application number: PCT/JP2020/040655
(87) International publication number: WO 2021/111780

(57) **Abstract**

The present invention provides: a lightweight optical member which can be produced at relatively low cost and which provides low reflectance, stability upon exposure to light, and abrasion resistance; and an efficient method for producing such an optical member. An optical member according to the present invention is characterized by comprising: a metallic base material; a low-reflective treatment layer formed on the surface of the metallic base material; and a silica layer formed on the surface of the low-reflective treatment layer. It is preferable for the silica layer to have a layer thickness of 0.1-10 µm.

## Description

### TECHINICAL FIELD

The present invention relates to an optical member whose surface reflectance is required to be reduced and a method for producing the same.

### PRIOR ART

The optical members used for various optical components (housing, various supports inside the housing, shutter blades, aperture, etc.) that make up optical devices such as digital cameras, digital video cameras, and mobile phones with cameras require lightweight and high rigidity, in addition, low light reflectance of the surface, and thus the blackness of the surface is generally increased. Here, since the target light has various wavelengths, it is desirable that the light reflectance of the optical member is minimized with respect to a specific wavelength.

Further, with regard to the pellicle frame for the pellicle, which is an optical component used in the lithography process, by making the surface of the frame black or dark, it is possible to more easily and surely perform a foreign object non-adhesion inspection before use. That is, from the viewpoint of inspectability, the surface of the pellicle frame is required to be black or dark.

In addition, with the recent miniaturization of LSI patterns, the wavelength of the exposure light source is becoming shorter. Since these exposure light sources of the short-wavelength have high output and high light energy, if inorganic acids such as sulfuric acid and phosphoric acid remain on the anodic oxide film on the surface of the pellicle frame, there is a problem that the acid reacts with a basic substance such as ammonia remaining in the exposure atmosphere to form a reaction product (haze) such as ammonium sulfate, and the reaction product causes cloudiness in the pellicle and affects the pattern transfer image.

Further, many optical members are slidable, and it is necessary to impart excellent wear resistance to the surface and strictly suppress dust generation. That is, the optical member is required to endow with many characteristics such as lightweight, high rigidity, low reflectance, stability against light irradiation, environmental resistance, and wear resistance.

On the other hand, for example, in Patent Literature 1 (JP 2010-237282 A), there is disclosed a method for producing a support frame for a pellicle which is formed with an aluminum material including aluminum or an aluminum alloy and includes an optical thin film body, an anodic oxidation film is formed on a surface of the aluminum material by anodic oxidation processing using an alkaline aqueous solution containing a tartaric acid, and the anodic oxidation film is subjected to dyeing processing using an organic dye and then is subjected to sealing processing by steam to obtain a support frame for the pellicle.

In Patent Literature 1, it is said that it possible to obtain a pellicle frame where the generation of haze is reduced as much as possible while having excellent corrosion resistance and durability by anodizing the aluminum material with an alkaline aqueous solution containing tartaric acid without using sulfuric acid, which is the largest causative substance of haze.

Further, in Patent Literature 2 (JP H07-43892), there is disclosed a pellicle characterized in that the side surface or the entire surface of a pellicle frame is coated with a paint by an electrodeposition coating method.

In the pellicle described in Patent Literature 2, it is said that since the side surface or the entire surface of the pellicle frame is coated with the paint by the electrodeposition coating method, the coating film is not uneven or porous like the alumite layer, and the coated surface is uniform and smooth, and thus the dust generation due to the transportation and movement of pellicle is completely prevented.

Further, in Patent Literature 3 (JP 2016-177120 A), there is disclosed a pellicle frame formed in a frame shape, wherein the pellicle frame is composed of a sintered body having a Young's modulus of 150 GPa or more and a Vickers hardness of 800 or more, the corner portion in the frame shape is secured to have a width equal to or larger than the width of the straight portion, and at least one of the corner portions is wider than the width of the straight portion, and the pellicle frame is made of ceramics, cemented carbide or cermet.

Since the pellicle frame described in Patent Literature 3 uses a sintered body having a high Young's modulus and Vickers hardness, it is possible to suppress the deformation due to the film tension generated when the pellicle film is stretched and provided on the pellicle frame. Moreover, it is said that, since the width of at least one corner portion is wider than the width of the straight portion, the strength of the corner portion can be increased, and the deformation and damage of the pellicle frame can be further suppressed.

### CITATION LIST

### Patent Literature

Patent Literature 1: JP 2010-237282 A
Patent Literature 2: JP H07-43892 A
Patent Literature 3: JP 2016-177120 A

### Summary of Invention

### Technical Problem

Although the pellicle frame described in Patent Literature 1 has excellent corrosion resistance, durability and stability against light irradiation, and the pellicle frame described in Patent Literature 2 has improved dust generation, low reflectance and wear resistance of the outermost surface (paint itself) are not considered.

Further, although the pellicle frame described in Patent Literature 3 is imparted with high strength and rigidity, a method having low reflectance, stability against light irradiation and wear resistance has not been studied. That is, the fact is that there is no suitable optical member that satisfies a wide range of requirements.

Considering the above problems in the prior art, an object of the present invention is to provide a lightweight optical member that can be produced at a relatively low cost, and has low reflectance, stability against light irradiation and wear resistance, and a method for efficiently producing the optical member.

### Solution to Problem

As a result of extensive study with respect to the optical member in order to achieve the above object, the present inventors have found that it is extremely effective in forming an appropriate low-reflective treatment layer on the surface of a metallic base material, and forming a silica layer on the surface of the low-reflective treatment layer, the present invention has been completed.

Namely, the present invention can provide an optical member characterized by comprising:
a metallic base material;
a low-reflective treatment layer formed on the surface of the metallic base material; and
a silica layer formed on the surface of the low-reflective treatment layer.

In the optical member of the present invention, the silica layer on the outermost surface imparts excellent wear resistance, and even when the low-reflective treatment layer is brittle, the dust generation from the low-reflective treatment layer can be effectively suppressed.

Further, in the conventional general optical member, a resin layer such as polyimide or acrylic is often formed on the outermost surface by electrodeposition coating or the like, but the resin layer has a low hardness and cannot impart sufficient wear resistance. On the other hand, the silica layer, which is a ceramic, has a sufficient hardness to realize the wear resistance required for the optical member.

Further, even if the silica layer is formed, the low reflectance due to the low-reflective treatment layer can be maintained, and, in addition thereto, the component causing haze can be suppressed from being released to the outside. That is, the greatest feature of the optical member of the present invention is to provide a dense silica layer on the outermost surface in a metal optical member.

In the optical member of the present invention, it is preferable that the layer thickness of the silica layer is 0.1 to 10 µm. By setting the layer thickness of the silica layer to 0.1 µm or more, a homogeneous and uniform silica layer can be formed, and by setting the layer thickness of the silica layer to 10 µm or less, the introduction of the defects in the silica layer can be suppressed and the toughness can be ensured. Further, the more preferable film thickness of the silica layer is 0.5 to 1.5 µm. Here, the method for forming the silica layer is not particularly limited as long as the effect of the present invention is not impaired, but for example, a chemical vapor deposition method (CVD) can be preferably used.

Further, in the optical member of the present invention, it is preferable that the metallic base material is made of aluminum or an aluminum alloy. By using aluminum or an aluminum alloy as the metallic base material, the lightness of the optical member can be ensured, and, in addition thereto, since these metals have excellent formability and machinability, an inexpensive optical member having a complicated shape can be realized.

Further, in the optical member of the present invention, it is preferable that the metallic base material is made of titanium or a titanium alloy. Titanium or a titanium alloy has a lower linear expansion coefficient than aluminum, and strain at the time of temperature rise is effectively suppressed. Further, titanium or a titanium alloy has a smaller specific gravity than steel or cemented carbide, and the optical member can be made lighter. In addition, titanium or a titanium alloy is a metallic material and has excellent toughness as compared with ceramics and cemented carbide, so that it is easy to handle. Further, because of having good processability, it is possible to reduce the production cost and to impart high dimensional accuracy to the optical member.

Further, in the optical member of the present invention, it is preferable that the low-reflective treatment layer is a porous layer. By making the low-reflective treatment layer a porous layer, it is not necessary to use additive elements other than the elements contained in the metallic base material, and it is not necessary to take further measures regarding weather resistance and stability against light irradiation. Here, the generation of dust is generally a problem in the porous layer, but in the optical member of the present invention, the generation of dust is suppressed extremely effectively by the silica layer formed on the outermost surface.

Furthermore, in the optical member of the present invention, it is preferable that the increase in the reflectance of visible light due to the silica layer is 5% or less. By setting the increase in the reflectance of visible light due to the silica layer to 5% or less, the reflectance of the optical member can be set to 10% or less.

Further, the present invention can also provide a method for producing an optical member characterized by comprising:
a low-reflective treatment step where a low-reflective treatment layer on the surface of a metallic base material is formed by subjecting to either of dyeing treatment of anodic oxide film, electrolytic coloring treatment of anodic oxide film, film thickness control of anodic oxide film, coating treatment of low-reflective film, or etching treatment using an aqueous solution which contains one or more kinds of ions selected from the group consisting of fluoride ion, borofluoride ion and silica fluoride ion, and a polar aprotonic solvent; and
a surface coating treatment for forming a silica layer having a thickness of 0.1 to 10 µm on the surface of the low-reflective treatment layer by a chemical vapor deposition method.

In the method for producing an optical member of the present invention, in the low-reflective treatment step, by subjecting to either of dyeing treatment of anodic oxide film, electrolytic coloring treatment of anodic oxide film, film thickness control of anodic oxide film, coating treatment of low-reflective film, or etching treatment using an aqueous solution which contains one or more kinds of ions selected from the group consisting of fluoride ion, borofluoride ion and silica fluoride ion, and a polar aprotonic solvent, it is possible to easily form the low-reflective treatment layer on the surface of the metallic base material. Here, in particular, when the metallic base material is titanium or a titanium alloy, by performing the etching treatment using an aqueous solution which contains one or more kinds of ions selected from the group consisting of fluoride ion, borofluoride ion and silica fluoride ion, and a polar aprotonic solvent, it is possible to form a porous low-reflectivity treatment layer while suppressing the introduction of haze-causing substances.

Further, in the method for producing an optical member of the present invention, by using a chemical vapor deposition method (CVD), it is possible to form a silica layer having a thickness of 0.1 to 10 µm which has few defects and is homogeneous and dense on the surface of the low-reflective treatment layer. Here, the type and process conditions of the chemical vapor deposition method are not particularly limited as long as the effects of the present invention are not impaired, and the conditions for forming a good silica layer of 0.1 to 10 µm may be appropriately adjusted. Examples of the chemical vapor deposition method includes, for example, a thermal CVD method, a plasma-induced CVD method, an optical CVD method, an atmospheric pressure CVD method, a reduced pressure CVD method, or a combination thereof. In addition, for forming the silica layer, it is possible to use a physical vapor deposition method (PVD), a dipping method, a spin coating method, and a spray coating method.

Further, in the method for producing an optical member of the present invention, it is preferable to adjust the reflectance of visible light according to a desired wavelength to 10% or less by the layer thickness of the silica layer. With respect to the optical member of the present invention, when the present inventors evaluated the relationship between the total reflectance and the wavelength of light, it became clear that the total internal reflectance of the optical member obtained under specific conditions differs depending on the wavelength, and when the vertical axis is the total reflection and the horizontal axis is the wavelength of light, the graph is wavy up and down. In addition, a phenomenon was observed in which the curve shifted in the horizontal axis (wavelength of light) direction depending on the film thickness of the silica layer. The results show that the total reflectance of any wavelength can be adjusted to a low value depending on the layer thickness of the silica layer.

Further, in the method for producing an optical member of the present invention, it is preferable that the metallic base material is made of any one of aluminum, an aluminum alloy, titanium and a titanium alloy. By using aluminum or an aluminum alloy as the metallic base material, the lightness of the optical member can be ensured, and, in addition thereto, since these metals have excellent formability and machinability, an inexpensive optical member having a complicated shape can be realized. Further, since titanium or a titanium alloy has good processability, it is possible to reduce the production cost and to impart high dimensional accuracy to the optical member.

### Effect of the Invention

According to the present invention, it is possible to provide a lightweight optical member which can be produced at relatively low cost and which provides low reflectance, stability upon exposure to light, and abrasion resistance; and an efficient method for producing such an optical member.

### BRIEF DESCRIPTION OF THE DRAWINGS

FIG. 1 is a schematic cross-sectional view of the optical member of the embodiment.
FIG. 2 is a graph which shows the reflectance of the present optical member 1.
FIG. 3 is a graph which shows the reflectance of the present optical member 2.

### Embodiments for achieving the invention

Hereinafter, representative embodiments of the optical member, and the producing method thereof according to the present invention will be described in detail with reference to the drawings, but the present invention is not limited to only these examples. Further, the elements in the embodiment can be optionally combined with a part or the whole. In the following description, the same or equivalent parts are denoted by the same numerals, and there is a case that redundant explanation may be omitted. In addition, since the drawings are for conceptually explaining the present invention, dimensions of the respective constituent elements expressed and ratios thereof may be different from actual ones.

### 1. Optical member

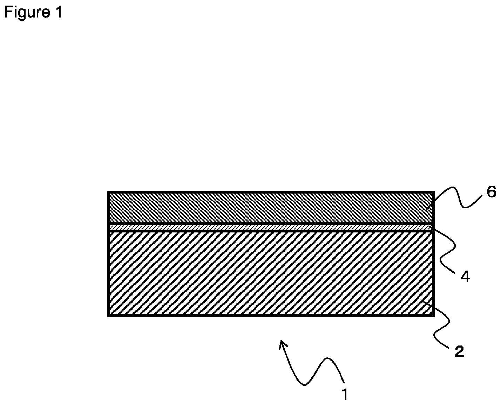

Although the optical member has a wide variety of shapes and sizes, FIG. 1 shows a schematic cross-sectional view in the case of a simple plate shape. The optical member 1 has a metallic base material 2, a low-reflective treatment layer 4 and a silica layer 6, the low-reflective treatment layer 4 is formed on the surface of the metallic base material 2, and the silica layer 6 is formed on the surface of the low-reflective treatment layer 4.

The material of the metallic base material 2 is not particularly limited as long as the effect of the present invention is not impaired, various conventionally known metal materials can be used, and it is preferable to use aluminum or an aluminum alloy from the viewpoint of lightweight, formability, cost, and the like, and it is preferable to use titanium or a titanium alloy from the viewpoint of suppressing strain at the time of temperature rise, rigidity, dimensional accuracy, and the like.

Here, when the metallic base material 2 is aluminum or an aluminum alloy, examples of the aluminum of 1000 series include A1050, A1050A, A1070, A1080, A1085, A1100, A1200, A1N00 and A1N30 described in the JIS standard, examples of the aluminum alloy of 3000 series include A3003, A3103, A3203, A3004, A3104, A3005 and A3105 described in the JIS standard, examples of the aluminum alloy of 5000 series include A5005, A5N01, A5021, 5N02 and A5042 described in the JIS standard, examples of the aluminum alloy of 6000 series include A6101, A6003, A6005, A6N01, A6151 and A6063 described in the JIS standard, and examples of the aluminum alloy of 7000 series include A7001, A7003, A7005, A7010, A7020, A7049, A7050, A7075, A7090, A7091, A7178, A7475 and A7N01.

Further, when the metallic base material 2 is titanium or a titanium alloy, examples include various industrial pure titanium (1 to 4 types), Ti-6Al-4V alloy, Ti-6Al-6V-2Sn alloy, Ti-6Al-2Sn-4Zr-6Mo alloy, Ti-10V-2Fe-3Al alloy, Ti-7Al-4Mo alloy, Ti-5Al-2.5Sn alloy, Ti-6Al-5Zr-0.5Mo-0.2Si alloy, Ti-5.5Al-3.5Sn-3Zr-0.3Mo-1Nb-0.3Si alloy, Ti-8Al-1Mo-1V alloy, Ti-6Al-2Sn-4Zr-2Mo alloy, Ti-5Al-2Sn-2Zr-4Mo-4Cr alloy, Ti-11.5Mo-6Zr-4.5Sn alloy, Ti-15V-3Cr-3Al-3Sn alloy, Ti-15Mo-5Zr-3Al alloy, Ti-15Mo-5Zr alloy, and Ti-13V-11Cr-3Al alloy.

When the metallic base material 2 is aluminum or an aluminum alloy, the low-reflective treatment layer 4 may be formed, for example, by forming an appropriate anodized film on the surface of the metallic base material 2, and being subjected to electrolytic coloring or dyeing with an organic dye. Further, a low-reflective film having a low reflectance may be coated by an appropriate method. When the metallic base material 2 is titanium or a titanium alloy, for example, there may be used the low-reflective treatment layer 4 utilizing the porosification of the surface of the metallic base material 2 or optical interference due to and the formation of an anodic oxide film having an appropriate film thickness. Further, a low-reflective film having a low reflectance may be coated by an appropriate method. That is, it is necessary to realize a low reflectance by the low-reflective treatment layer 4, but it is sufficient to form an appropriate one from the viewpoint of the type of the metallic base material 2, the producing cost, and the like.

The silica layer 6 is formed on the surface of the low-reflective treatment layer 4, and the layer thickness is preferably 0.1 to 10 µm. By setting the layer thickness of the silica layer 6 to 0.1 µm or more, it is possible to obtain a homogeneous and uniform thickness, and by setting the layer thickness to 10 µm or less, the introduction of defects into the silica layer 6 is suppressed, and the toughness can be ensured.

Further, since the silica layer 6 determines the wear resistance and scratch resistance of the optical member 1, the hardness of the silica layer 6 is preferably 250 HV or more, more preferably 300 HV or more, and most preferably 350 HV or more. Here, the hardness of the silica layer 6 may be a value measured from the surface of the optical member 1 with a Micro Vickers hardness tester. More specifically, for example, a hardness obtained with an applied load of an indenter of 0.05 g and a holding time of 15 seconds can be employed.

The reflectance of the optical member 1 is preferably 10% or less, more preferably 8% or less with respect to the target light. By setting the reflectance to 10% or less, it is possible to sufficiently suppress light reflection in various optical devices, pellicle frames, and the like. These reflectances are preferably satisfied with respect to the wavelength of light required depending on the use of the optical member, and for example, when LED light is targeted, it is preferably satisfied with the range of 500 to 550 nm. Further, by suppressing the reflected light including visible light, it is possible to perform good optical observation of the optical member using a camera. In this specification, the reflectance means a value measured by the method described in Example.

Further, the brightness index (L* value: the brightness index according to the color difference formula of the hunter) of the optical member 1 is preferably 50 or less, and more preferably 40 or less. By setting the surface brightness index L* value to 50 or less, light reflection of various optical components can be sufficiently suppressed. Further, in the case of a pellicle frame, it is possible to easily and surely perform a foreign matter adhesion inspection before use. In this specification, the brightness index L* value means a value measured by the method described in Example.

Further, since the surface of the optical member 1 is covered with the silica layer 6, the elution of ions from the optical member 1 is extremely small. Here, in an ion elution test in which the optical member 1 is immersed in 100 ml of a pure water at 90 °C for 3 hours to measure the elution ion concentration, an elution concentration in 100 ml of a pure water per 50 cm² of the surface area is preferably 100 ppb or less of acetate ion, 200 ppb or less of formate ion, 10 ppb or less of chlorine ion, 10 ppb or less of nitrate ion, 10 ppb or less of nitrite ion, and 10 ppb or less of ammonium ion. By controlling the elution amounts of these ions, the generation of the haze can be lowered to the utmost.

Examples of the optical member 1 include a pellicle frame, a lens holder, a barrel, a shade, a reflector, and the like.

### 2. Method for producing an optical member

The method for producing an optical member of the present invention includes a low-reflective treatment step (S01) where a low-reflective treatment layer 4 on the surface of a metallic base material 2 is formed by subjecting the metallic base material 2 to either of dyeing treatment of anodic oxide film, electrolytic coloring treatment of anodic oxide film, film thickness control of anodic oxide film, coating treatment of low-reflective film, or etching treatment using an aqueous solution which contains one or more kinds of ions selected from the group consisting of fluoride ion, borofluoride ion and silica fluoride ion, and a polar aprotonic solvent; and a surface coating treatment (S02) for forming a silica layer 6 having a thickness of 0.1 to 10 µm on the surface of the low-reflective treatment layer 4 by a chemical vapor deposition method.

### (1) Low-reflective treatment step (S01)

The purpose of the low-reflective treatment step (S01) is to form the low-reflective treatment layer 4 on the surface of the metallic base material 2 to reduce the reflectance of the surface of the metallic base material 2.

As long as the effect of the present invention is not impaired, the method of low-reflective treatment is not particularly limited, and various conventionally known treating methods may be used. Here, when the metallic base material 2 is titanium or a titanium alloy, by etching treatment using an aqueous solution which contains one or more kinds of ions selected from the group consisting of fluoride ion, borofluoride ion and silica fluoride ion, and a polar aprotonic solvent, it is possible to form a porous layer on the surface of the metallic base material 2, and a decrease in reflectance and blackening can be achieved.

Further, as a pretreatment for the low-reflective treatment, the surface of the metallic base material 2 may be roughened or chemically polished. For example, a shot blast treatment using an appropriate medium can be used for the roughening, and an etching treatment using an appropriate etching solution can be used for the chemical polishing.

### (2) Surface coating treatment (S02)

The purpose of the surface coating treatment (S02) is to form the silica layer 6 on the outermost surface of the optical member 1 to impart excellent wear resistance and scratch resistance to the optical member 1, and, in addition, to suppress ion elution from the inside. Further, at this time, it is necessary to suppress the increase in the reflectance and the brightness index lowered by the low-reflective treatment step (S01).

By using a chemical vapor deposition method (CVD), it is possible to form a silica layer 6 having a thickness of 0.1 to 10 µm which has few defects and is homogeneous and dense on the surface of the low-reflective treatment layer 4. Here, the type and process conditions of the chemical vapor deposition method are not particularly limited as long as the effects of the present invention are not impaired, and the conditions for forming a good silica layer 6 of 0.1 to 10 µm may be appropriately adjusted. Examples of the chemical vapor deposition method includes, for example, a thermal CVD method, a plasma-induced CVD method, an optical CVD method, an atmospheric pressure CVD method, a reduced pressure CVD method, or a combination thereof. In addition, for forming the silica layer 6, it is possible to use a physical vapor deposition method (PVD), a dipping method, a spin coating method, and a spray coating method.

Further, as described above, the reflectance of the optical member 1 can be adjusted by the thickness of the silica layer 6. The thickness of the silica layer 6 can be easily changed depending on the CVD conditions, and may be adjusted by, for example, the processing time, the processing temperature, the processing atmosphere, and the like. Here, when the silica layer 6 is formed on a lens or the like by using the CVD method, the layer thickness of the silica layer 6 often stays at about several tens of nm to several hundreds of nm, but the layer thickness of the silica layer 6 is 0.1 to 10 µm, and, for example, it is necessary to lengthen the processing time as compared with the conventional general CVD conditions.

Although the typical embodiments of the present invention have been described above, the present invention is not limited to these, and various design changes are possible, and all of these design changes are included in the technical scope of the present invention.

### EXAMPLE

### <Example 1>

A 50 mm × 50 mm × 3 mm plate material made of A7075 aluminum alloy was subjected to surface roughening treatment by spraying a stainless steel medium at a pressure of 0.1 MPa. Then, after an anodic oxide film was formed using a solution containing tartaric acid, a low-reflective treatment layer was formed by a dyeing treatment. As the anodic oxidation treatment, constant voltage electrolysis was performed by using an alkaline aqueous solution (pH = 13.0) in which 53 g/L of sodium tartrate dihydrate (Na₂C₄H₄O₆.2H₂O) and 4 g/L of sodium hydroxide were dissolved as an electrolytic solution, at the bath temperature of 5 °C, at the electrolytic voltage of 40 V for 20 minutes. Then, after washing with pure water, when the anodized film formed on the surface of the A7075 aluminum alloy plate material was confirmed with an eddy current type film thickness meter (available from Fisher Instruments Co., Ltd.), the film thickness was 6.6 µm.

With respect to the dyeing treatment, the anodized A7075 aluminum alloy plate material was placed in an aqueous solution containing an organic dye (TAC411 available from Okuno Pharmaceutical Co., Ltd.) at a concentration of 10 g/L and immersed at a temperature of 55 °C for 10 minutes.

Next, the silica layer was formed on the surface of the low-reflective treatment layer by using a chemical vapor deposition method (plasma CVD method). Specifically, a gaseous precursor mixture containing a silane compound, oxygen and a radical trapping agent was passed in the vicinity of the A7075 aluminum alloy plate amterial, the gaseous precursor mixture was reacted at about 600 °C on the surface of the A7075 aluminum alloy plate material, and a silica layer having a layer thickness of 1 µm was formed to obtain the present optical member 1.

### <Example 2>

A 50 mm × 50 mm × 1 mm plate material made of industrial pure titanium (Type 2) was subjected to the surface roughening treatment in the same manner as in Example 1. Then, an etching treatment was performed for 240 seconds using an aqueous solution containing a fluoride ion and a polar aprotic solvent to form a porous low-reflective treatment layer.

Next, in the same manner as in Example 1, a silica layer having a layer thickness of 1 µm was formed on the surface of the low-reflective treatment layer to obtain the present optical member 2.

### <Comparative Example 1>

After the surface roughening treatment, a low-reflective treatment layer was formed in the same manner as in Example 1. Next, a polyimide layer was formed on the surface of the low-reflective treatment layer by electrodeposition coating to obtain the comparative optical member 1. Here, the conditions for the electrodeposition coating were a processing voltage of 200 V and a processing time of 3 minutes.

### <Comparative Example 2>

The comparative optical member 2 was obtained in the same manner as in Comparative Example 1 except that an acrylic layer was formed on the surface of the low-reflective treatment layer by electrodeposition coating.
Here, the conditions for the electrodeposition coating were a processing voltage of 100 V and a processing time of 3 minutes.

### <Comparative Example 3>

The comparative optical member 3 was obtained in the same manner as in Example 1 except that the silica layer was not formed.

### <Comparative Example 4>

The comparative optical member 4 was obtained in the same manner as in Example 2 except that the silica layer was not formed.

### [Evaluation]

### 1. Brightness index

The brightness index L* of the present optical members 1 and 2 and the comparative optical member 1 was measured using a brightness measuring device (NF777, available from Nippon Denshoku Kogyo Co., Ltd.). The thus obtained results are shown in Table 1.

**[Table 1]**

| | L* |
|---|---|
| Present optical member 1 | 34.9 |
| Present optical member 2 | 36.2 |
| Comparative optical member 1 | 29.1 |

As shown in Table 1, it can be seen that although the L* values of the present optical members 1 and 2 on which the silica layer was formed increases as compared with the comparative optical member 1 on which the resin layer (polyimide layer) was formed, the obtained value is 40 or less.

### 2. Reflectance

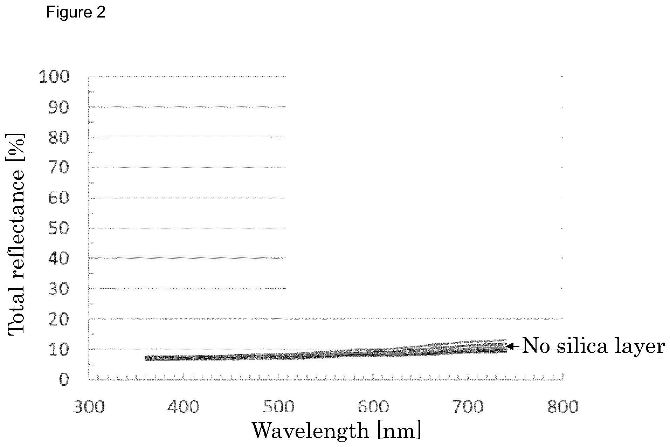

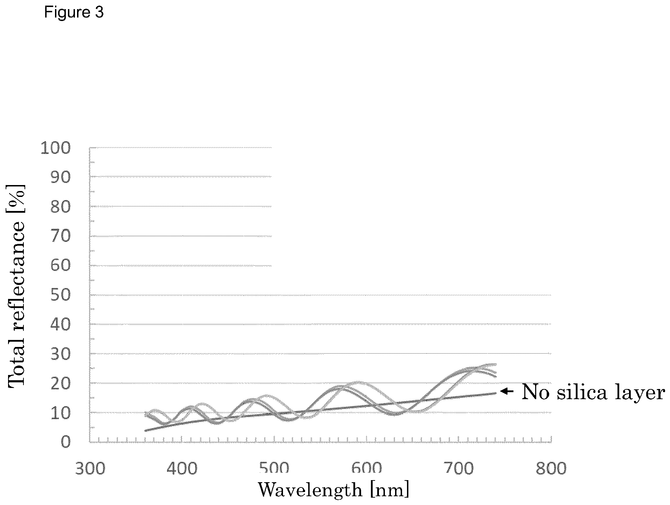

The reflectance of the present optical members 1 and 2 was measured using a reflectance measuring device (Lambda750, available from PerkinElmer Co., Ltd.). The measurement result of the present optical member 1 is shown in FIG. 2, and the measurement result of the present optical member 2 is shown in FIG. 3. With respect to the present optical member 1, the measurement was performed for each of the eight samples prepared under the same conditions, and also for the state before forming the silica layer as a comparison. Further, with respect to the present optical member 2, the measurement was performed for each of the four samples prepared under the same conditions, and also for the state before forming the silica layer as a comparison.

As shown in FIG. 2, the reflectance of the present optical member 1 has a small variation among the wavelengths of the target light and the measurement samples, and is a low value of about 10%. Further, almost no increase in reflectance due to the formation of the silica layer is observed.

Further, as shown in FIG. 3, the reflectance of the present optical member 2 changes with respect to the wavelength of the target light, and increases or decreases in the range of 5 to 30%. Further, the situation of the increase / decrease differs depending on the measurement sample, but this depends on the film thickness of the silica layer, and by slightly changing the film thickness of the silica layer, the reflectance for a specific wavelength can be adjusted to a low value (10% or less). Further, from this viewpoint, almost no increase in reflectance due to the formation of the silica layer is observed.

### 3. Evaluation of dust generation property

The dust generation property was evaluated for the present optical members 1 and 2 and the comparative optical members 3 and 4. Specifically, these optical members were immersed in pure water, and after washing ultrasonically for 1 minute, the number of particles in 3 L of the pure water was measured with a particle counter (NP500T, available from Nippon Denshoku Kogyo Co., Ltd.). Table 2 shows a relative comparison of the number of particles having a particle size of 0.5 µm or more. Here, since the presence / absence of the silica layer is different between the present optical member 1 and the comparative optical member 3, and between the present optical member 2 and the comparative optical member 4, in order to clarify the influence of the silica layer, there are shown the relative value of the number of particles of the present optical member 1 when the number of particles of the optical member 3 is 1, and the relative value of the number of particles of the present optical member 2 when the number of particles of the comparative optical member 4 is 1, respectively.

**[Table 2]**

| | Silica layer | Number of particles |
|---|---|---|
| Present optical member 1 | Exist | 0.7 |
| Comparative optical member 3 | Non | 1 |
| Present optical member 2 | Exist | 0.6 |
| Comparative optical member 4 | Non | 1 |

As shown in Table 2, the number of particles having a particle size of 0.5 µm or more is significantly reduced by the formation of the silica layer, and in case of the comparison between the present optical member 1 and the comparative optical member 3, the reduction is 30%, and in case of the comparison between the present optical member 2 and the comparative optical member 4, the reduction is 40%.

### 4. Ion elution amount

The ion elution amount was evaluated for the present optical members 1 and 2 and the comparative optical member 2. Specifically, these optical members were immersed in 100 ml of pure water and heat-treated at 90 °C for 3 hours. After that, the amount of ions in the eluate (pure water) was measured by an ion chromatograph. Table 3 shows the amount of ion elution per 100 ml of pure water. The unit of the amount of ion elution is ppb.

**[Table 3]**

| | Anion | | | | | | | | Cation |
|---|---|---|---|---|---|---|---|---|---|
| | Acetic acid | Formic acid | Cl | N02 | N03 | SO4 | Oxalic acid | P04 | NH4 |
| Present optical member 1 | 66 | 186 | 10 | 7 | 8 | 0 | 0 | 1 | 9 |
| Present optical member 2 | 4 | 18 | 3 | 1 | 2 | 0 | 0 | 1 | 3 |
| Comparative optical member 2 | 185 | 422 | 2 | 2 | 7 | 0 | 0 | 0 | Not measured |

As shown in Table 3, the amount of ion elution from the present optical members 1 and 2 is generally small, and the values for sulfate ion and NH₄ ion are also no problem. Here, comparing the present optical member 1 and the comparative optical member 2 having the same configuration except that the outermost surface layer is different, it can be seen that the elution of acetic acid and formic acid is effectively suppressed in the present optical member 1 having the outermost surface of the silica layer.

### 5. Hardness measurement

The hardness of the surface of the optical member of the present optical members 1, 2 and the comparative optical members 1, 2, 4 were measured with a Micro Vickers hardness tester (HM-221, available from Mitutoyo Co., Ltd.) under the conditions of an applied load of 0.05 g, a holding time of 15 seconds. The hardness was measured 5 times, and the thus obtained results are shown in Table 4.

**[Table 4]**

| | Vickers hardness (Hv) | | | | | |
|---|---|---|---|---|---|---|
| | 1 | 2 | 3 | 4 | 5 | Average |
| Present optical member 1 | 364 | 290 | 307 | 350 | 357 | 333 |
| Present optical member 2 | 262 | 266 | 301 | 280 | 330 | 288 |
| Comparative optical member 1 | 288 | 312 | 283 | 296 | 316 | 299 |
| Comparative optical member 2 | 266 | 266 | 237 | 249 | 261 | 256 |
| Comparative optical member 4 | 210 | 181 | 184 | 184 | 226 | 197 |

As shown in Table 4, when comparing the average values of Vickers hardness among the present optical member 1, the comparative optical member 1 and the comparative optical member 2 where the A7075 aluminum alloy plate material are used as a base material, the present optical member 1 has 333 Hv, the optical member 1 has 299 Hv and the comparative optical member 2 has 256 Hv, and it can be seen that excellent wear resistance is imparted by providing the silica layer on the outermost surface.

Further, when comparing the average value of the Vickers hardness of the present optical member 2 and the comparison optical member 4 where the industrial pure titanium (Type 2) plate material are used as the base material, the present optical member 2 has 288 Hv and the comparative optical member 4 has 197 Hv, and it can be seen that excellent wear resistance is imparted by providing the silica layer on the outermost surface.

Here, when comparing the average values of the Vickers hardness between the present optical member 1 and the present optical member 2 where the silica layer is provided on the outermost surface, the hardness of the present optical member 1 using the A7075 aluminum alloy plate material as a base material is higher, which shows that, under the current measurement conditions, the mechanical properties of the base material affect the Vickers hardness even when the silica layer is provided on the outermost surface.

### Explanation of Symbols

- 1: Optical member,
- 2: Metallic base material,
- 4: Low reflectance treatment layer,
- 6: Silica layer.

## Claims

1. An optical member **characterized by** comprising: a metallic base material; a low-reflective treatment layer formed on the surface of the metallic base material; and a silica layer formed on the surface of the low-reflective treatment layer.

2. The optical member according to claim 1, wherein a layer thickness of the silica layer is 0.1 to 10 µm.

3. The optical member according to claim 1 or 2, wherein the metallic base material is made of aluminum or an aluminum alloy.

4. The optical member according to claim 1 or 2, wherein the metallic base material is made of titanium or a titanium alloy.

5. The optical member according to any one of claims 1 to 4, wherein the increase in the reflectance of visible light due to the silica layer is 5% or less.

6. A method for producing an optical member **characterized by** comprising:
a low-reflective treatment step where a low-reflective treatment layer on the surface of a metallic base material is formed by subjecting to either of dyeing treatment of anodic oxide film, electrolytic coloring treatment of anodic oxide film, film thickness control of anodic oxide film, coating treatment of low-reflective film, or etching treatment using an aqueous solution which contains one or more kinds of ions selected from the group consisting of fluoride ion, borofluoride ion and silica fluoride ion, and a polar aprotonic solvent; and
a surface coating treatment for forming a silica layer having a thickness of 0.1 to 10 µm on the surface of the low-reflective treatment layer by a chemical vapor deposition method.

7. The method for producing an optical member according to claim 6, wherein the reflectance of visible light is adjusted according to a desired wavelength to 10% or less by the layer thickness of the silica layer.

8. The method for producing an optical member according to claim 6 or 7, wherein the metallic base material is made of any one of aluminum, an aluminum alloy, titanium, and a titanium alloy.
